(19) Europäisches Patentamt / European Patent Office / Office européen des brevets

(11) **EP 4 024 011 B1**

(12) **FASCICULE DE BREVET EUROPEEN**

(45) Date de publication et mention de la délivrance du brevet:
**24.05.2023 Bulletin 2023/21**

(21) Numéro de dépôt: **21218476.6**

(22) Date de dépôt: **31.12.2021**

(51) Classification Internationale des Brevets (IPC):
**G01R 22/06** $^{(2006.01)}$    **G01D 4/00** $^{(2006.01)}$
**G01F 15/06** $^{(2022.01)}$    **G01F 15/02** $^{(2006.01)}$
**G01F 1/00** $^{(2022.01)}$

(52) Classification Coopérative des Brevets (CPC):
**G01F 15/06; G01D 4/00; G01F 1/00; G01F 15/02;**
G01D 2204/10; G01R 22/061

(54) **ADAPTATION DE L'AFFICHAGE EN FONCTION DE L'ORIENTATION DU COMPTEUR**

ANPASSUNG DER ANZEIGE JE NACH AUSRICHTUNG DES ZÄHLERS

ADAPTATION OF DISPLAY ACCORDING TO THE POSITION OF THE METER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.01.2021 FR 2100016**

(43) Date de publication de la demande:
**06.07.2022 Bulletin 2022/27**

(73) Titulaire: **Sagemcom Energy & Telecom SAS**
**92500 Rueil Malmaison (FR)**

(72) Inventeurs:
• **SABRAOUI, Abbas**
  **92500 RUEIL MALMAISON (FR)**
• **WEBER, Patrick**
  **92500 RUEIL MALMAISON (FR)**
• **LECOCQ, Guillaume**
  **92500 RUEIL MALMAISON (FR)**

(74) Mandataire: **Lavaud, Thomas et al**
**Cabinet Boettcher**
**16, rue Médéric**
**75017 Paris (FR)**

(56) Documents cités:
**AU-A1- 2019 249 271    JP-B2- 6 675 900**
**US-A1- 2007 219 650    US-B2- 10 812 879**

**Description**

L'invention concerne le domaine des compteurs : compteurs d'eau, de gaz, de pétrole, d'électricité, etc.

ARRIERE PLAN DE L'INVENTION

De nombreux compteurs modernes comprennent sur leur face avant un afficheur grâce auquel un opérateur en intervention sur le compteur, ou bien un utilisateur (un abonné par exemple), peut accéder à certaines informations : données de consommation, données contractuelles, données de surveillance du compteur, etc.

Au moment de l'installation du compteur, il est relativement fréquent que l'opérateur en charge de l'installation soit confronté à des contraintes liées à l'intégration du compteur dans son environnement d'accueil, et par exemple à un espace disponible réduit ou difficile d'accès, à un positionnement particulier des arrivées de l'électricité ou des tuyaux d'eau, etc.

La position dans laquelle le compteur est installé et son orientation résultent alors d'un compromis entre ces contraintes d'intégration et le confort de lecture pour l'opérateur ou l'utilisateur, et il n'est pas rare que l'opérateur choisisse de monter le compteur dans une position et selon une orientation qui ne sont pas optimales vis-à-vis de la visibilité de l'afficheur.

Cette situation peut provoquer des erreurs de lecture (surtout dans le cas où l'afficheur est à l'envers), tend à compliquer les interventions réalisées sur le compteur (à l'installation et en opération), et empêche l'utilisateur de bénéficier pleinement des services offerts par le compteur.

Le brevet JP 6 675 900 B2 divulgue un compteur avec un affichage adaptable connu dans l'art antérieur.

OBJET DE L'INVENTION

L'invention a pour objet d'améliorer la visibilité de l'afficheur d'un compteur.

RESUME DE L'INVENTION

En vue de la réalisation de ce but, on propose un compteur comprenant un dispositif de mesure principal agencé pour produire des mesures d'au moins une grandeur relative à un élément distribué via le compteur à une installation reliée au compteur, le compteur comprenant de plus :

- un afficheur ;
- un capteur d'orientation agencé pour produire des mesures de l'orientation du compteur par rapport à la direction de la pesanteur terrestre ;
- une unité de traitement reliée au capteur d'orientation et à l'afficheur, et agencée pour adapter une orientation d'un affichage de caractères sur l'afficheur en fonction de l'orientation du compteur ;

l'unité de traitement étant en outre agencée pour détecter une installation du compteur dans une position opérationnelle, pour acquérir au moins une mesure d'orientation suite à ladite détection, puis pour adapter si nécessaire l'orientation de l'affichage en fonction de la mesure d'orientation ;
l'unité de traitement étant en outre agencée pour détecter l'installation du compteur dans la position opérationnelle lorsqu'au moins une grandeur mesurée par le dispositif de mesure principal est supérieure à un seuil de mesure prédéterminé ou lorsqu'une présence de l'élément est détectée par le compteur.

L'adaptation de l'orientation de l'affichage en fonction de l'orientation du compteur permet de rendre visibles et compréhensibles les caractères affichés sur l'afficheur et ce, quelle que soit l'orientation du compteur lorsque celui-ci est monté dans sa position opérationnelle (en service). L'adaptation de l'orientation de l'affichage est réalisée par l'unité de traitement de manière automatique, et ne nécessite pas d'action particulière de l'opérateur.

On propose aussi un compteur tel que précédemment décrit, comprenant en outre un organe détecteur agencé pour détecter un phénomène externe, l'unité de traitement étant agencée pour acquérir au moins une mesure d'orientation suite à une détection dudit phénomène externe par l'organe détecteur, puis pour adapter si nécessaire l'orientation de l'affichage en fonction de la mesure d'orientation.

On propose aussi un compteur tel que précédemment décrit, l'organe détecteur étant agencé pour détecter une commande produite par un individu, l'unité de traitement étant agencée pour détecter l'installation du compteur dans la position opérationnelle suite une détection par l'organe détecteur de ladite commande.

On propose aussi un compteur tel que précédemment décrit, l'organe détecteur étant un bouton poussoir.

On propose aussi un compteur tel que précédemment décrit, l'organe détecteur étant agencé de sorte qu'un individu peut conférer à l'orientation de l'affichage une valeur choisie en agissant sur l'organe détecteur.

On propose aussi un compteur tel que précédemment décrit, dans lequel l'unité de traitement est agencée pour, si les mesures d'orientation sont indisponibles ou erronées, conférer à l'orientation de l'affichage une valeur prédéfinie.

On propose aussi un compteur tel que précédemment décrit, comprenant en outre un contrôleur relié ou intégré dans l'unité de traitement, et agencé pour commander l'affichage des caractères sur l'afficheur.

On propose aussi un compteur tel que précédemment décrit, dans lequel le contrôleur est agencé, pour adapter l'orientation de l'affichage, pour sélectionner en fonction de l'orientation du compteur un codage optimisé parmi une pluralité de codages mémorisés qui codent chacun des caractères à afficher en signaux de commande produits par le contrôleur.

On propose aussi un compteur tel que précédemment décrit, dans lequel le contrôleur est agencé, pour adapter l'orientation de l'affichage, pour sélectionner en fonction de l'orientation du compteur une table d'association optimisée parmi une pluralité de tables d'association mémorisées qui associent chacun des signaux de commande produits par le contrôleur à des broches du contrôleur connectées à des broches de l'afficheur.

On propose aussi un compteur tel que précédemment décrit, comprenant en outre un module de communication agencé pour transmettre les mesures d'orientation à une entité située à l'extérieur du compteur.

On propose aussi un compteur tel que précédemment décrit, l'unité de traitement étant en outre agencée pour corriger des mesures d'au moins une grandeur en fonction de l'orientation du compteur.

On propose aussi un compteur tel que précédemment décrit, le compteur étant un compteur d'eau.

On propose de plus un procédé d'affichage, mis en oeuvre dans un compteur tel que précédemment décrit et comprenant les étapes de :

- acquérir des mesures de l'orientation du compteur produites par le capteur d'orientation ;
- adapter l'orientation de l'affichage des caractères sur l'afficheur en fonction de l'orientation du compteur.

On propose de plus un programme d'ordinateur comprenant des instructions qui conduisent l'unité de traitement du compteur tel que précédemment décrit à exécuter les étapes du procédé d'affichage tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en oeuvre particulier non limitatif de l'invention.

BREVE DESCRIPTION DES DESSINS

Il sera fait référence aux dessins annexés parmi lesquels :

[Fig. 1] la figure 1 représente un compteur d'eau selon l'invention ;
[Fig. 2] la figure 2 représente des modules fonctionnels du compteur ;
[Fig. 3] la figure 3 représente des étapes d'un procédé d'affichage ;
[Fig. 4] la figure 4 représente un afficheur ;
[Fig. 5] la figure 5 représente un tableau comprenant les segments éclairés d'un afficheur LCD en fonction des broches de commande activées, ainsi que ledit afficheur LCD ;
[Fig. 6] la figure 6 représente deux tables d'association des signaux de commande et des broches de commande ;
[Fig. 7] la figure 7 représente un micro-écoulement dans un compteur en position horizontale ;
[Fig. 8] la figure 8 représente un micro-écoulement dans un compteur en position verticale ;
[Fig. 9] la figure 9 représente une grille de correction ;
[Fig. 10] la figure 10 représente le compteur, le conduit, l'afficheur, les axes de l'accéléromètre, la direction de la pesanteur terrestre et l'angle d'orientation du compteur ; [Fig. 11] la figure 11 représente un graphique qui illustre la sélection des ensembles de données de correction en fonction de l'orientation du compteur.

DESCRIPTION DETAILLEE DE L'INVENTION

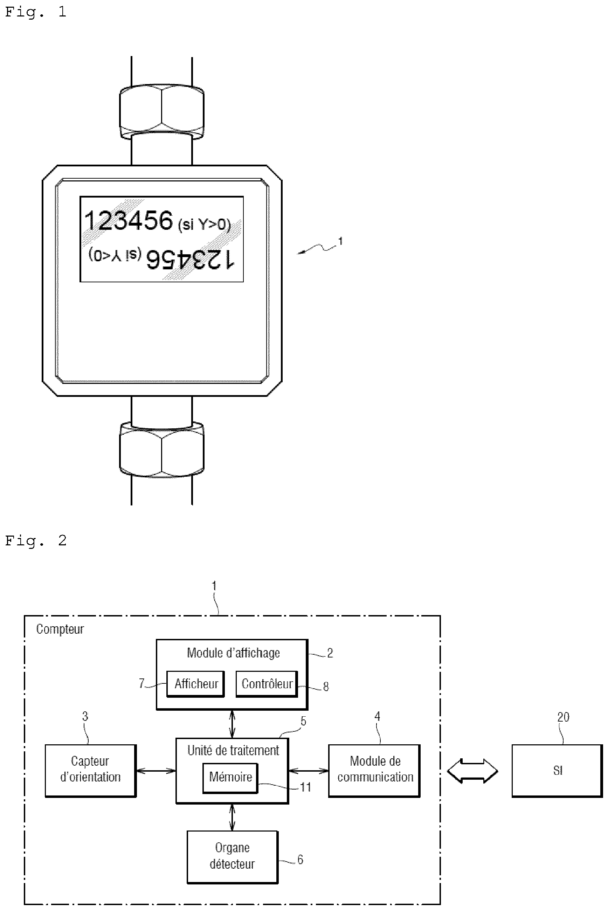

En référence aux figures 1 et 2, l'invention est ici mise en oeuvre dans un compteur d'eau ultrasonique 1. Le compteur d'eau 1 comporte un dispositif de mesure principal (non représenté), un module d'affichage 2, un capteur d'orientation 3, un module de communication 4, une unité de traitement 5 et un organe détecteur 6.

On décrit tout d'abord rapidement chacun de ces éléments.

Le dispositif de mesure principal permet de produire des mesures d'au moins une grandeur relative à un élément distribué via le compteur 1 à une installation reliée au compteur 1. Ici, l'élément est l'eau, et le dispositif de mesure principal produit des mesures du débit d'eau et du volume d'eau qui circulent et qui sont consommés par l'installation. Le compteur 1 comporte un conduit dans lequel circule l'eau. Dans le mode de réalisation décrit ici, le dispositif de mesure principal comporte deux transducteurs piézoélectriques comprenant un transducteur amont et un transducteur aval. Les termes « amont » et « aval » doivent être interprétés par rapport au sens de circulation privilégié de l'eau dans le conduit.

Le dispositif de mesure principal fonctionne de la manière suivante.

Le transducteur amont émet un signal ultrasonore de mesure qui parcourt le trajet d'amont en aval et qui est reçu par le transducteur aval. Le transducteur aval émet un signal ultrasonore de mesure qui parcourt le trajet d'aval en amont et qui est reçu par le transducteur amont. La vitesse moyenne de l'eau est estimée à partir de la différence entre les temps de vol, le débit d'eau est calculé à partir de la vitesse moyenne de l'eau, et le volume d'eau correspond à l'intégrale du débit d'eau sur le temps.

Le module d'affichage 2 comprend ici un afficheur LCD à segments 7 (LCD pour *Liquid Crystal Display*) et un contrôleur 8.

Le capteur d'orientation 3 est ici un accéléromètre triaxial, comprenant donc trois capteurs qui mesurent des accélérations linéaires selon trois axes orthogonaux x, y et z. Le capteur d'orientation 3 peut estimer la direction de la pesanteur terrestre et permet ainsi de produire des mesures de l'orientation du compteur 1. Les mesures de l'orientation permettent de déterminer précisément l'orientation du compteur 1 lorsque celui-ci est installé dans sa position opérationnelle, c'est-à-dire dans la position qu'il occupe lorsqu'il est en service.

Le module de communication 4 permet au compteur 1 de communiquer avec un Système d'Information (SI) 10 du gestionnaire du parc de compteurs, éventuellement via un concentrateur de données, une passerelle, ou bien un autre compteur (tel qu'un compteur d'eau communicant de quartier). Le module de communication 4 est susceptible de mettre en œuvre tout type de communication, et par exemple une communication via un réseau cellulaire de type 2G, 3G, 4G, Cat-M ou NB-IOT, une communication selon le protocole LoRaWan ou Sigfox, une communication radio selon le standard *Wize* opérant à la fréquence de 169MHz, une communication en NFC ou en BLE, etc. Le compteur 1 transmet au SI 10 via le module de communication 4, à intervalles réguliers, les mesures réalisées.

L'unité de traitement 5 comprend au moins un composant de traitement qui est adapté à exécuter des instructions d'un programme (ou de plusieurs programmes) pour mettre en œuvre les opérations qui vont être décrites plus bas. L'unité de traitement 5 comprend aussi une mémoire 11 reliée ou intégrée dans le composant de traitement 5. Le programme est stocké dans la mémoire 11. Le composant de traitement est par exemple un processeur, un DSP (pour *Digital Signal Processor*), un microcontrôleur, ou bien un circuit logique programmable tel qu'un FPGA (pour *Field Programmable Gate Arrays*) ou un ASIC (pour *Application Spécifie Integrated Circuit*).

L'organe détecteur 6 est ici un bouton poussoir et permet à un opérateur présent à proximité du compteur 1 de communiquer avec l'unité de traitement 5 et, en particulier, de transmettre des commandes à l'unité de traitement 5 pour que celle-ci pilote à son tour un ou des composants du compteur 1 en réponse à ces commandes.

Les mesures d'orientation produites par le capteur d'orientation 3 sont tout d'abord utilisées pour adapter l'orientation de l'affichage de caractères sur l'afficheur 7 de manière à améliorer le confort de lecture pour un opérateur ou pour un utilisateur.

En effet, le compteur d'eau 1, lorsqu'il est en service et est donc monté dans sa position opérationnelle, n'est pas toujours orienté selon une orientation qui permet à l'opérateur ou à l'utilisateur de lire correctement l'afficheur 7.

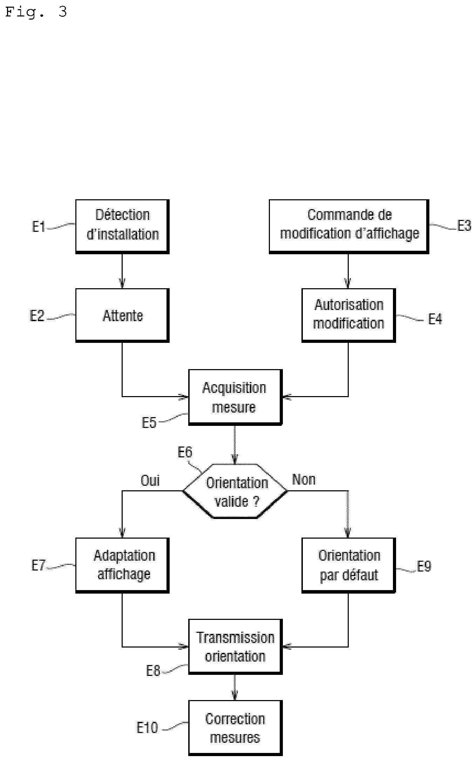

Le procédé d'affichage permettant d'adapter l'orientation de l'affichage en fonction de l'orientation du compteur 1 est décrit en référence à la figure 3.

Le procédé d'affichage est mis en oeuvre dans l'unité de traitement 5. La conversion de l'information de la direction de la pesanteur terrestre en une orientation du compteur 1 est faite sur la base d'un écart minimum entre la direction et le sens du vecteur de la force de gravité et de ceux représentant les orientations possibles de l'afficheur 7. On peut aussi ne conserver que les informations du vecteur de la pesanteur terrestre dans la direction correspondant à l'afficheur 7, et définir l'orientation de l'affichage à l'aide du sens du vecteur.

Le procédé démarre lorsque l'unité de traitement 5 détecte l'installation du compteur 1 dans sa position opérationnelle (étape E1).

L'unité de traitement 5 détecte que le compteur 1 a été installé dans sa position opérationnelle lorsqu'au moins une grandeur mesurée par le dispositif de mesure principal du compteur 1 est supérieure à un seuil de mesure prédéterminé. Ici, en l'occurrence, l'unité de traitement 5 détecte que le compteur 1 a été installé dans sa position opérationnelle lorsque le débit d'eau, mesuré par le dispositif de mesure principal, devient supérieur à un seuil de débit prédéterminé (étape E1).

Alternativement, l'unité de traitement 5 pourrait détecter que le compteur 1 a été installé dans sa position opérationnelle lorsque la présence de l'eau est détectée par le compteur.

Alternativement encore, on peut prévoir que, suite à l'installation du compteur 1, l'opérateur en charge de ladite installation utilise le bouton poussoir 6 pour transmettre à l'unité de traitement 5 l'information selon laquelle le compteur 1 a été installé.

Suite à l'installation du compteur 1, le procédé d'affichage comprend une étape d'attente, d'une durée prédéterminée, typiquement égale à quelques minutes (étape E2).

Le procédé d'affichage peut aussi démarrer suite à une commande de modification de l'orientation de l'affichage effectuée par l'opérateur via le bouton poussoir 6 (étape E3). La commande n'est pas nécessairement effectuée au moment de l'installation du compteur 1 mais peut être réalisée à tout moment de la vie du compteur 1. Il est en effet possible par exemple qu'un opérateur, lorsqu'il intervient sur le compteur 1, ne soit pas satisfait de l'orientation de l'affichage et décide de la modifier ou de la forcer. Le bouton poussoir 6 permet en effet à un individu de conférer à l'orientation de l'affichage une valeur choisie en agissant sur le bouton poussoir 6.

L'unité de traitement 5 vérifie alors que la commande est valide et, éventuellement, que l'opérateur ou l'utilisateur est autorisé à produire une telle commande (en vérifiant un identifiant par exemple). Si la commande est valide, l'unité de traitement 5 autorise ladite commande (étape E4).

Suite à l'étape E2 ou à l'étape E4, l'unité de traitement 5 acquiert au moins une mesure d'orientation du compteur 1. Ici, l'unité de traitement 5 acquiert une pluralité de mesures d'orientation et produit une donnée d'orientation à partir des mesures d'orientation. La donnée d'orientation est par exemple une moyenne de plusieurs mesures d'orientation (étape E5).

Puis, l'unité de traitement 5 vérifie que la donnée d'orientation est valide (étape E6). Ici, l'unité de traitement 5 considère que la donnée d'orientation est valide lorsque les mesures d'orientation sont stables pendant une durée prédéterminée, c'est-à-dire que la variation des mesures d'orientation en valeur absolue est inférieure à un seuil de variation prédéterminé pendant la durée prédéterminée. La durée prédéterminée est par exemple égale à une minute. Le seuil de variation prédéterminé est par exemple égal à 100 milli-G sur chaque axe de l'accéléromètre ou du module du vecteur d'accélération.

Si la donnée d'orientation est valide, l'unité de traitement 5 adapte l'orientation de l'affichage des caractères sur l'afficheur 7 en fonction de l'orientation du compteur 1 (étape E7).

Le module de communication 4 transmet alors au SI 10, via le module de communication 4, la nouvelle orientation de l'affichage, c'est-à-dire l'orientation de l'affichage qui vient d'être commandée par l'unité de traitement 5 (étape E8).

On rend ainsi disponible un rapport d'installation du compteur 1 incluant son sens du montage, afin que le gestionnaire du parc soit capable d'établir une carte de déploiement, ou d'étudier son parc en fonction du positionnement des compteurs (fiabilité, encrassement, etc.). Le rapport d'installation peut être envoyé à l'installation du compteur 1, ou plus tard, sur la base d'apparitions d'erreurs ou d'événements particuliers (tels qu'une requête, une fraude, un vol ou une fuite).

Le gestionnaire du parc peut ainsi construire une collecte de données et mettre en oeuvre une gestion du parc par l'analyse de la consommation, des erreurs et de la durée de vie (et de toute autre information disponible par les compteurs ou par ailleurs) en fonction de cette orientation. Par exemple, le gestionnaire du parc peut surveiller les dépôts de calcaire ou de sable sur les compteurs les plus exposés et corréler cette information avec la métrologie, en direct et par retour de parc. Le gestionnaire du parc peut s'assurer que les orientations privilégiées d'installation sont respectées sur son parc. Par exemple, il peut vérifier que les compteurs sont bien installés pour garantir une durée de vie maximale desdits compteurs.

Suite à l'étape E6, si la donnée d'orientation n'est pas valide, l'unité de traitement 5 confère à l'orientation de l'affichage une valeur d'orientation par défaut (étape E9). Le module de communication 4 transmet alors au SI 10 la nouvelle orientation de l'affichage (c'est-à-dire la valeur d'orientation par défaut) : étape E8.

Lorsqu'une nouvelle orientation de l'affichage a été définie, l'unité de traitement 5 adapte si nécessaire les données de correction utilisées pour corriger les mesures de débit d'eau (étape E10). Ce point sera développé plus bas dans la présente description.

On s'intéresse maintenant à la manière dont l'unité de traitement 5 adapte l'orientation de l'affichage des caractères sur l'afficheur 7.

Ici, deux orientations de l'affichage sont disponibles : un affichage normal et un affichage retourné.

Par « affichage normal », on entend un affichage qui est tel que, lorsque le compteur 1 est positionné en service selon son orientation nominale, c'est-à-dire lorsque la partie haute du compteur 1 est orientée vers le haut et la partie basse est orientée vers le bas, un individu qui se trouve devant la face avant du compteur 1 voit les caractères affichés à l'endroit.

Par « affichage retourné », on entend un affichage sur lequel les caractères sont à l'envers, c'est à dire retournés par rapport à l'affichage normal.

Ici, on utilise la projection de la direction de la pesanteur terrestre sur l'axe x de l'accéléromètre pour déterminer si un affichage normal doit être utilisé, ou bien si un affichage retourné doit être utilisé. Si cette projection est positive, l'affichage normal doit être utilisé. Si cette projection est négative, l'affichage retourné doit être utilisé.

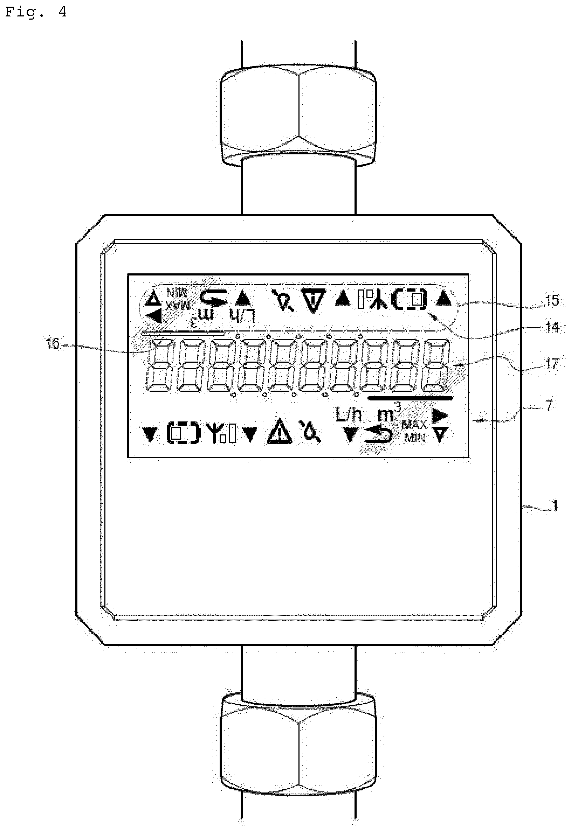

En référence à la figure 4, l'afficheur 7 permet d'afficher des caractères qui comprennent des icônes 14 (situés dans le cartouche 15), une barre de soulignement 16, et des caractères alphanumériques 17.

La barre de soulignement 16 permet d'indiquer la partie décimale affichée d'un nombre. Cette barre de soulignement 16 est requise par les normes de métrologie en vigueur.

Ici, les icônes 14 ainsi que la barre de soulignement 16 sont dupliqués, lors du passage de l'affichage normal à l'affichage retourné, par symétrie par rapport au centre de l'afficheur 7.

Ainsi, lorsque l'affichage normal est utilisé, les icônes 14 apparaissent dans la portion inférieure de l'afficheur 7 (le terme « inférieur » étant défini par rapport à l'orientation nominale du compteur 1). Au contraire, lorsque l'affichage retourné est utilisé, les icônes 14 apparaissent dans la portion supérieure de l'afficheur 7, et retournés.

Par conséquent, lorsque le compteur 1 est monté à l'envers, de sorte que sa partie basse est orientée vers le haut et sa partie haute est orientée vers le bas, les icônes 14 et la barre de soulignement 16 apparaissent, lorsqu'elles sont vues par l'opérateur, comme si elles se trouvaient dans la partie basse de l'afficheur 7, et comme si elles étaient à l'endroit.

On s'intéresse maintenant à l'adaptation de l'orientation de l'affichage des caractères.

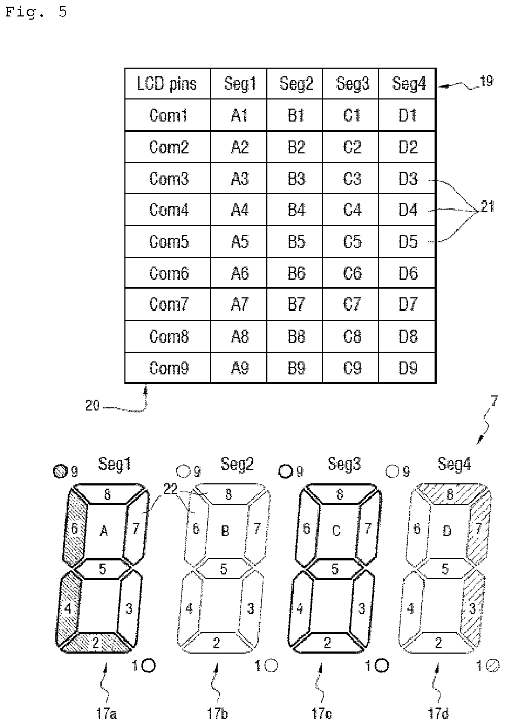

En référence à la figure 5, l'afficheur 7 présenté ici est un afficheur LCD à segments. L'afficheur 7 comporte des broches de commande SEG et des broches de commande COM. Ici, l'afficheur 7 peut afficher quatre caractères alphanumériques 17 et comporte quatre broches de commande SEG (SEG1, ..., SEG4) et neuf broches de commande COM (COM1, ..., COM9).

L'afficheur 7 peut afficher quatre caractères dans l'exemple de la figure 5 : 17a, 17b, 17c et 17d.

L'afficheur 7 est commandé via un circuit matriciel.

Les broches de commande SEG définissent les colonnes du circuit matriciel et les broches de commande COM définissent les lignes du circuit matriciel (ou inversement).

Le tableau de la figure 5 comprend une ligne supérieure 19 comprenant les broches de commande SEG et une colonne de gauche 20 comprenant les broches de commande COM de l'afficheur 7. Le tableau comprend aussi les identifiants 21 des segments 22 qui sont allumés lorsque des tensions positives (formant des états hauts) sont appliquées sur lesdites broches de commande.

Par exemple, lorsque des tensions positives sont appliquées sur les broches de commande Seg4, Com1, Com3, Com7 et Com8, les segments D1, D3, D7, et D8 du caractère 17d sont allumés et le caractère 17d affiche la valeur « 7. ». Les autres caractères 17a, 17b, 17c sont éteints, car des tension nulles (formant des états logiques bas) sont appliquées sur les autres broches de commande. Cette valeur « 7. » est visible à l'endroit lorsque l'affichage normale est utilisé.

C'est le contrôleur 8 qui applique les états logiques hauts et les états logiques bas sur les broches de commande.

Pour afficher un caractère, le contrôleur 8 acquiert ledit caractère, transforme le caractère en signaux de commande électriques (comprenant les états logiques hauts et les états logiques bas) qui sont appliqués sur des broches de commande du contrôleur 8 qui sont elles-mêmes reliées aux broches de commande de l'afficheur 7.

Les caractères sont codés en signaux de commande selon un codage mémorisé.

Les différents signaux de commande produits par le contrôleur 8 sont associés aux broches de commande du contrôleur 8 (et donc aux broches de commande de l'afficheur 7) selon une table d'association.

L'adaptation de l'orientation de l'affichage peut consister à sélectionner en fonction de l'orientation du compteur 1 un codage optimisé parmi une pluralité de codages mémorisés qui codent chacun des caractères à afficher en signaux de commande produits par le contrôleur 8.

Ici, l'unité de traitement 5 sélectionnera un premier codage mémorisé pour mettre en oeuvre l'affichage normal, et un deuxième codage mémorisé pour mettre en oeuvre l'affichage retourné, et commandera le contrôleur 8 de sorte que celui-ci utilise le codage sélectionné.

Ainsi, pour que le caractère 17d prenne la valeur « 7. » dans l'affichage normal, le premier codage mémorisé est utilisé. Selon le premier codage mémorisé, pour afficher le caractère « 7. », le contrôleur 8 produit les signaux de commande qui activent les broches de commande Seg4, Com1, Com3, Com7 et Com8 de l'afficheur 7 (c'est-à-dire qui appliquent un état logique haut sur lesdites broches de commande).

Par contre, pour que le caractère 17d prenne la valeur « 7. » dans un affichage retourné, le deuxième codage mémorisé est utilisé. Selon le deuxième codage mémorisé, pour afficher le caractère « 7. », le contrôleur 8 produit les signaux de commande qui activent les broches de commande Seg1, Com2, Com4, Com6 et Com9. Le caractère 17d est donc vu à l'endroit, lorsque le compteur 1 est monté à l'envers, c'est-à-dire lorsque la partie haute du compteur 1 est orientée vers le bas et la partie basse est orientée le haut, par un individu qui se trouve devant la face avant du compteur 1.

L'adaptation de l'orientation de l'affichage peut aussi consister à sélectionner en fonction de l'orientation du compteur 1 une table d'association optimisée parmi une pluralité de tables d'association mémorisées qui associent chacune des signaux de commande produits par le contrôleur 8 connectées à des broches de commande de l'afficheur 7.

Ici, l'unité de traitement 5 sélectionnera une première table d'association pour mettre en oeuvre l'affichage normal, et une deuxième table d'association pour mettre en oeuvre l'affichage retourné, et commandera le contrôleur 8 de sorte que celui-ci utilise la table d'association sélectionnée.

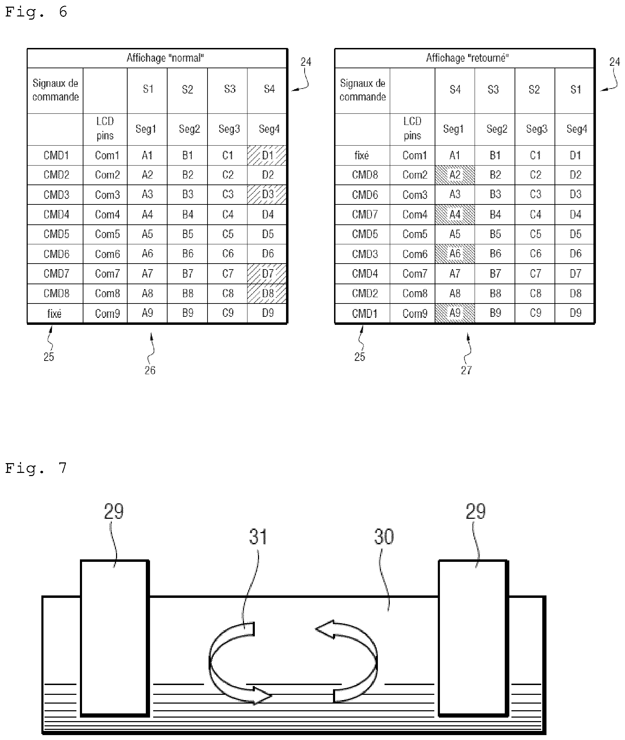

On illustre cela en référence à la figure 6.

Les signaux de commande produits par le contrôleur 8 sont visibles sur la ligne supérieure 24 et sur la colonne de gauche 25, et sont appelés S1,..., S4 et CMD1, ..., CMD9.

Pour mettre en oeuvre l'affichage normal, la première table d'association 26 est utilisée. Selon la première table d'association 26, les signaux de commande S1, ..., S4 sont appliqués sur les broches de commande du contrôleur 8 reliées respectivement aux broches de commande Seg1, ..., Seg4 de l'afficheur 7, et les signaux de commande CMD1, ..., CMD9 sont appliqués sur les broches de commande du contrôleur 8 reliées respectivement aux broches de commande Com1, ..., Com9 de l'afficheur 7.

Pour mettre en oeuvre l'affichage retourné, la deuxième table d'association 27 est utilisée. Selon la deuxième table d'association 27, les signaux de commande S1, ..., S4 sont appliqués sur les broches de commande du contrôleur 8 reliées respectivement aux broches de commande Seg4, ..., Seg1 de l'afficheur 7, et les signaux de commande CMD1, ..., CMD9 sont appliqués sur les broches de commande du contrôleur 8 reliées respectivement aux broches de commande Com9, ..., Com1 de l'afficheur 7.

Ainsi, lorsque l'affichage normal est mis en oeuvre, pour que le caractère de droite affiche la valeur « 7. », les signaux de commande CMD1, CMD3, CMD7, CMD8 et S4 sont activés et vont allumer les segments D1, D3, D7 et D8.

Lorsque l'affichage retourné est mis en oeuvre, les mêmes signaux de commande sont activés et vont allumer les segments A2, A4, A6 et A9, de sorte que le caractère de gauche prend la valeur « 7. » retournée.

Avec cette méthode, le codage des caractères en signaux de commande ne doit pas être modifié. Seule une reconfiguration des broches de commande du contrôleur 8 est nécessaire. Les mêmes signaux de commande provenant du contrôleur 8 mais arrivant sur des broches de commande différentes de l'afficheur 7 vont afficher les caractères à l'envers.

Les deux méthodes qui viennent d'être décrites sont applicables quel que soit le nombre de caractères alphanumériques à afficher. Elles sont aussi applicables pour mettre en oeuvre l'affichage normal ou l'affichage retourné des icônes 14 et de la barre de soulignement 16.

Les mesures d'orientation du compteur 1 sont aussi utilisées pour améliorer la précision des mesures du débit d'eau réalisées par le dispositif de mesure principal.

L'orientation du compteur 1 peut en effet avoir un impact sur la précision de mesures.

Lorsque la température ambiante est différente de la température de l'eau qui circule dans le compteur 1, un phénomène de convection se produit (convection naturelle ou thermique).

La mesure de la vitesse d'écoulement de l'eau (qui est une image du débit d'eau) est alors perturbée par les micro-écoulements parasites dus à la convection et à la recirculation, ce qui fausse les mesures du débit d'eau, notamment pour les bas débits (inférieurs à 5 litres/heure).

Or, la maîtrise de la mesure à bas débit est nécessaire pour garantir une détection fiable des fuites qui doit être indépendante des phénomènes de convection.

L'impact de la convection est d'autant plus grand que la distance entre les transducteurs est importante.

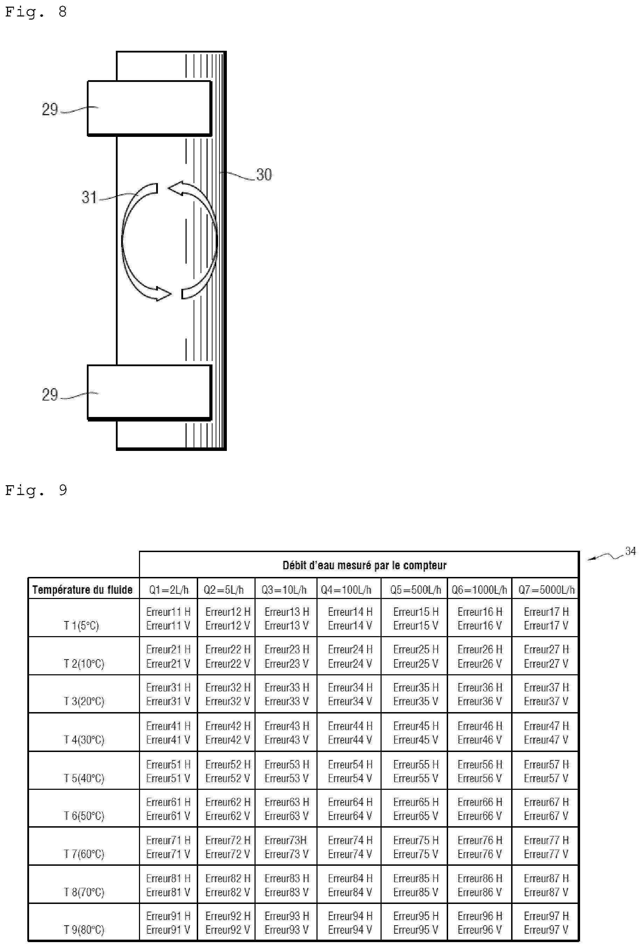

Les transducteurs 29 et le conduit 30 du compteur 1 sont visibles sur les figures 7 et 8. En référence à la figure 7, lorsque le compteur 1 se trouve dans une position horizontale, c'est-à-dire que l'axe du conduit 30 du compteur 1 s'étend horizontalement, l'impact de la convection est minimisé car la convection se réalise dans la largeur du conduit 30. Les micro-écoulements 31 présentent une amplitude relativement limitée. Par contre, lorsque le compteur 1 se trouve dans une position verticale, c'est-à-dire que l'axe du conduit 30 du compteur 1 s'étend verticalement (parallèlement à la direction de la pesanteur terrestre), la convection se fait dans la longueur du tube 30 et son impact sur les mesures est plus important. L'amplitude des micro-écoulements 31 est plus importante.

Ce phénomène est aussi plus important si l'espacement entre les transducteurs 29 est plus important, comme c'est le cas pour des conduits 30 de longueur plus importante (DN20, D40, etc).

On notera que la matière du conduit 30 a aussi une influence sur cette convection, qui dépend de la résistance thermique du matériau. Cependant, cette influence est déjà prise en compte lors de la calibration standard du conduit 30.

L'unité de traitement 5 va donc corriger les mesures de débit d'eau en fonction de la position horizontale ou verticale du dispositif de mesure principal, et donc à partir des mesures d'orientation.

L'unité de traitement 5 peut accéder à au moins deux ensembles de données de correction mémorisés dans la mémoire 11, et corriger les mesures du débit d'eau en utilisant au moins l'un des ensembles de données de correction.

Ici, deux ensembles de données de correction sont mémorisés : un premier ensemble de données de correction est associé à la position horizontale du compteur 1 et donc du conduit 30, c'est-à-dire à une orientation de référence égale à 90° ou à 270° par rapport à la direction de référence qui est la direction de la pesanteur terrestre (direction verticale), et un deuxième ensemble de données de correction qui est associé à la position verticale du compteur 1 et donc du conduit 30, c'est-à-dire à une orientation de référence égale à 0° ou à 180° par rapport à la direction de référence.

Les données de correction de chaque ensemble de données de correction comprennent des valeurs d'erreur qui dépendent du débit d'eau et de la température de l'eau.

Les deux ensembles de données de correction sont stockés dans une grille de correction 34, visible sur la figure 9, et dans un espace mémoire de la mémoire 11 de l'unité de traitement 5, qui comprend des cases mémoire.

La grille de correction 34 comprend des indices d'erreur associés chacun à une valeur de la grandeur mesurée, c'est-à-dire à une valeur de débit d'eau, et à une température de l'eau. Chaque indice d'erreur (Erreur11H, Erreur 11V,..., Erreur 97H, Erreur 97V) pointe vers une case mémoire dans laquelle une valeur d'erreur est stockée. Les valeurs d'erreur ont été déterminées au moment de la phase de calibration du compteur 1. On note que la grille de correction 34 est la même pour tous les compteurs semblables au compteur 1 : ce sont les valeurs d'erreur qui diffèrent selon les compteurs.

Dans la grille de correction 34, chaque indice d'erreur est donc associé à la fois à un débit d'eau mesuré par le compteur 1, à une température de l'eau et à une orientation du compteur 1 (horizontale ou verticale).

Lorsqu'un « H » est inclus à la fin de l'indice d'erreur, cela signifie que la donnée de correction appartient au premier ensemble de données de correction, et donc que la valeur d'erreur s'applique pour le compteur 1 en position horizontale. Lorsqu'un « V » est inclus à la fin d'un indice d'erreur, cela signifie que la donnée de correction appartient au deuxième ensemble de données de correction (vertical), et donc que la valeur d'erreur s'applique pour le compteur 1 en position verticale.

Les valeurs d'erreur sont des pourcentages d'erreur qui sont définis durant une opération de mesure au cours de la phase de calibration du compteur 1. Cette opération de mesure consiste à faire s'écouler dans le conduit du compteur 1 un débit d'eau de référence, sous une température donnée, et à mesurer le débit d'eau de référence avec un débitmètre de référence « étalonné ». Le débit mesuré par le compteur est enregistré.

Le pourcentage d'erreur Pe est tel que :

$$Pe = \frac{Débit\ mesuré - Débit\ de\ référence}{Débit\ de\ référence} \times 100.$$

Ainsi, par exemple, le pourcentage d'erreur contenu dans la case mémoire vers laquelle pointe l'indice d'erreur « Erreur11 H » est égal à 30%, et le pourcentage d'erreur contenu dans la case mémoire vers laquelle pointe l'indice d'erreur « Erreur11 V » est égal à 40%. Ainsi, pour un débit d'eau de 2 L/h et une température de 5°C, l'écart entre le débit de référence et le débit mesuré est de 30% en position horizontale et de 40% en position verticale.

Lorsque le débit d'eau mesuré ainsi que la température mesurée se trouvent entre deux valeurs de la grille de correction 34, on applique des règles de trois pour définir la valeur d'erreur à appliquer.

On note qu'à partir d'un débit d'eau supérieur ou égal à 100L/h, l'écart entre l'erreur dans la position horizontale et l'erreur dans la position verticale est très faible. Ainsi, lorsque le débit d'eau est supérieur à un seuil de débit prédéterminé, ici égal à 100L/h, on utilisera le même pourcentage d'erreur pour la position horizontale et la position verticale du compteur 1.

Le pourcentage d'erreur est par exemple égal à -15% pour la position horizontale et -15% pour la position verticale, pour une température de 5°C et un débit d'eau mesuré par le compteur de 100L/h. Le pourcentage d'erreur est par exemple égal à -10% pour la position horizontale et -10% pour la position verticale, pour une température de 5°C et un débit d'eau mesuré par le compteur de 500L/h.

Ainsi, pour une température de l'eau et un débit d'eau donnés, on peut, lorsque le débit d'eau est supérieur au seuil de débit prédéterminé, prévoir que la grille de correction 34 ne contient qu'un indice d'erreur qui pointe vers une seule case mémoire.

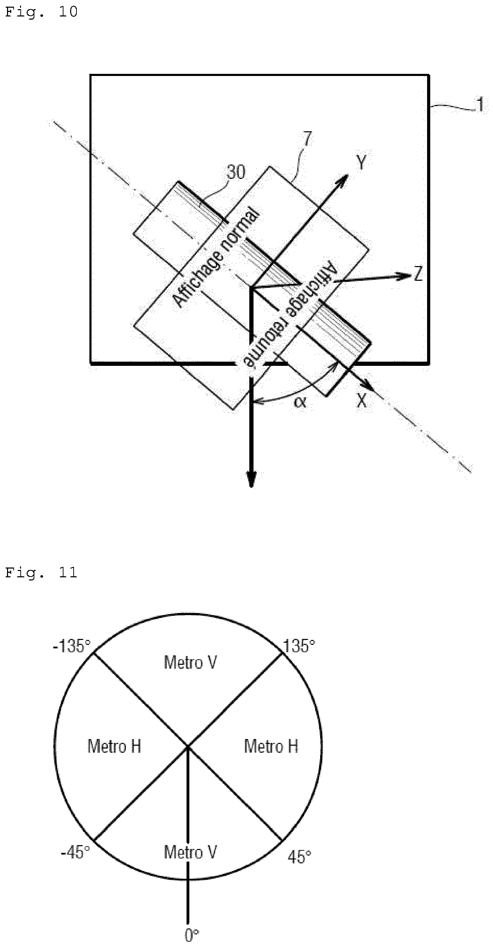

Dans un premier mode de réalisation, en référence aux figures 10 et 11, l'unité de traitement 5 sélectionne en fonction de l'orientation du compteur 1 un seul ensemble de données de correction, et utilise uniquement les données de correction dudit ensemble de données de correction pour corriger les mesures du débit d'eau.

Ici, le premier ensemble de données de correction (Metro H) est utilisé lorsque l'orientation $\alpha$ du compteur 1 (et donc du conduit 30) est comprise entre 45° et 135° et entre -135° et -45° par rapport à la direction de la pesanteur terrestre, et le deuxième ensemble de données de correction (Metro V) est utilisé lorsque l'orientation du compteur 1 (et donc du conduit 30) est comprise entre 135° et -135° et entre -45° et 45° par rapport à la direction de la pesanteur terrestre.

Dans un deuxième mode de réalisation, l'unité de traitement 5 utilise des données de correction d'au moins deux ensembles de données de correction pour corriger les mesures du débit d'eau, et applique des coefficients aux données de correction desdits ensembles de données de correction, lesdits coefficients dépendant de l'orientation du compteur 1.

L'unité de traitement 5 utilise donc à la fois les données de correction du premier ensemble de données de correction et celles du deuxième ensemble de données de correction.

On a ici :

Erreur = cos$\alpha$ $\times$ ErreurH + sin$\alpha$ $\times$ erreurV, où $\alpha$ est l'orientation du compteur 1, ErreurH est la valeur d'erreur qui est associée, pour la position horizontale, à l'indice d'erreur qui correspond dans la grille de correction 34 au débit d'eau mesuré et à la température de l'eau mesuré, et ErreurV est la valeur d'erreur qui est associée, pour la position verticale, à l'indice d'erreur qui correspond dans la grille de correction 34 au débit d'eau mesuré et à la température de l'eau mesurée.

La correction des mesures de débit d'eau proposée ici implique des opérations mathématiques simples (par exemple, une interpolation linéaire au lieu d'une interpolation polynomiale). L'unité de traitement 5 du compteur 1 ne nécessite donc pas de mobiliser une forte puissance de calcul et cela permet donc avantageusement de réduire la consommation électrique dudit compteur 1. Ceci est particulièrement avantageux si le compteur 1 est destiné à être alimenté via une pile. En effet, la réduction de la consommation électrique du compteur 1 permet d'alimenter ledit compteur 1, via la pile, sur une longue période de temps (par exemple, plus de 10 ans).

Bien entendu, l'invention n'est pas limitée au mode de réalisation décrit mais englobe toute variante entrant dans le champ de l'invention telle que définie par les revendications.

L'invention peut être mise en œuvre dans tout type de compteur : compteur de liquide, de gaz, de pétrole, d'énergie thermique, d'électricité, etc. Dans le cas d'un compteur électrique, l'élément fourni à l'installation est une énergie électrique, un courant ou une puissance.

Le dispositif de mesure principal peut mesurer une ou plusieurs grandeurs relatives à l'élément fourni à l'installation.

Dans le cas d'un compteur électrique, l'élément fourni est l'électricité et les grandeurs sont par exemple une énergie électrique, une puissance, un courant ou une tension.

Dans le cas d'un compteur de fluide, les grandeurs comprennent par exemple le débit du fluide, le volume, la température, la composition, la turbidité, la présence de corps étranger, le sens, la direction, etc. Toutes ces mesures peuvent être corrigées en fonction de l'orientation du compteur.

Le capteur d'orientation qui a été décrit est agencé pour produire des mesures de l'orientation du compteur, dans un plan vertical, par rapport à la direction de la pesanteur terrestre.

Le capteur d'orientation n'est pas nécessairement un accéléromètre, mais peut être un autre type de capteur, et notamment un autre type de capteur capable de définir la direction et le sens de pesanteur terrestre : ampoule mercure, balancier à contact, bille à contacts multiples, etc.

Le capteur d'orientation peut aussi être un capteur magnétique qui produit des mesures de l'orientation du compteur, dans un plan horizontal, par rapport au champ magnétique terrestre. Dans ce cas, les au moins deux ensembles de données de correction qui ont été décrits plus tôt comprennent cette fois un premier ensemble de données de correction associé à une orientation de référence qui est une orientation vers le Nord du compteur, et un deuxième ensemble de données de correction associé à une orientation de référence qui est une orientation vers le Sud du compteur.

L'afficheur n'est pas nécessairement un afficheur LCD à segments, ni même un afficheur LCD.

L'architecture du compteur peut être différente de celle présentée sur la figure 2. Le contrôleur du module d'affichage pourrait par exemple être intégré dans l'unité de traitement.

L'organe détecteur n'est pas nécessairement un bouton poussoir.

L'organe détecteur est agencé pour détecter un phénomène externe.

Le phénomène externe peut être une interaction (une commande par exemple) initiée par un individu situé à proximité ou à distance du compteur, ou bien par une entité (concentrateur de données, SI, etc.) située à proximité ou à distance du compteur. L'organe détecteur peut ainsi être un moyen quelconque d'interface homme-machine, par exemple un module NFC ou un module radio.

Le phénomène externe peut aussi être un phénomène physique quelconque, par exemple un choc subi par le compteur, un fort niveau de champ magnétique, etc. Dans ce cas, l'organe détecteur peut comprendre un capteur : magnétique, de choc, de vibration, de lumière, etc.

On a décrit ici que l'affichage mis en oeuvre sur l'afficheur peut être soit un affichage normal, soit un affichage retourné. Il est possible de prévoir des affichages différents qui dépendent de l'orientation du compteur, par exemple un affichage associé à une orientation de 45°.

De même, il est possible de prévoir des ensembles de correction différents, associés à des orientations différentes du compteur.

**Revendications**

1. Compteur (1) comprenant un dispositif de mesure principal agencé pour produire des mesures d'au moins une grandeur relative à un élément distribué via le compteur (1) à une installation reliée au compteur (1), le compteur comprenant de plus :

   - un afficheur (7) ;
   - un capteur d'orientation (3) agencé pour produire des mesures de l'orientation du compteur par rapport à la direction de la pesanteur terrestre ;
   - une unité de traitement (5) reliée au capteur d'orientation et à l'afficheur, et agencée pour adapter une orientation d'un affichage de caractères (14, 16, 17) sur l'afficheur en fonction de l'orientation du compteur ; le dit compteur (1) étant **caractérisé par**:

l'unité de traitement (5) étant en outre agencée pour détecter une installation du compteur (1) dans une position opérationnelle, pour acquérir au moins une mesure d'orientation suite à ladite détection, puis pour adapter si nécessaire l'orientation de l'affichage en fonction de la mesure d'orientation ;
l'unité de traitement (5) étant en outre agencée pour détecter l'installation du compteur (1) dans la position opérationnelle lorsqu'au moins une grandeur mesurée par le dispositif de mesure principal est supérieure à un seuil de mesure prédéterminé ou lorsqu'une présence de l'élément est détectée par le compteur.

2. Compteur selon la revendication 1, comprenant en outre un organe détecteur (6) agencé pour détecter un phénomène externe, l'unité de traitement étant agencée pour acquérir au moins une mesure d'orientation suite à une détection dudit phénomène externe par l'organe détecteur, puis pour adapter si nécessaire l'orientation de l'affichage en fonction de la mesure d'orientation.

3. Compteur selon la revendication 2, l'organe détecteur (6) étant agencé pour détecter une commande produite par un individu, l'unité de traitement (5) étant agencée pour détecter l'installation du compteur (1) dans la position opérationnelle suite une détection par l'organe détecteur de ladite commande.

4. Compteur selon la revendication 2, l'organe détecteur étant un bouton poussoir.

5. Compteur selon la revendication 2, l'organe détecteur étant agencé de sorte qu'un individu peut conférer à l'orientation de l'affichage une valeur choisie en agissant sur l'organe détecteur.

6. Compteur selon l'une des revendications précédentes, dans lequel l'unité de traitement (5) est agencée pour, si les mesures d'orientation sont indisponibles ou erronées, conférer à l'orientation de l'affichage une valeur prédéfinie.

7. Compteur selon l'une des revendications précédentes, comprenant en outre un contrôleur (8) relié ou intégré dans l'unité de traitement, et agencé pour commander l'affichage des caractères sur l'afficheur (7).

8. Compteur selon la revendication 7, dans lequel le contrôleur (8) est agencé, pour adapter l'orientation de l'affichage, pour sélectionner en fonction de l'orientation du compteur (1) un codage optimisé parmi une pluralité de codages mémorisés qui codent chacun des caractères à afficher en signaux de commande produits par le contrôleur (8).

9. Compteur selon la revendication 7, dans lequel le contrôleur (8) est agencé, pour adapter l'orientation de l'affichage, pour sélectionner en fonction de l'orientation du compteur (1) une table d'association optimisée parmi une pluralité de tables d'association mémorisées qui associent chacun des signaux de commande produits par le contrôleur (8) à des broches du contrôleur (8) connectées à des broches de l'afficheur (7).

10. Compteur selon l'une des revendications précédentes, comprenant en outre un module de communication (4) agencé pour transmettre les mesures d'orientation à une entité (10) située à l'extérieur du compteur.

11. Compteur selon l'une des revendications précédentes, l'unité de traitement étant en outre agencée pour corriger des mesures d'au moins une grandeur en fonction de l'orientation du compteur.

12. Compteur selon la revendication 11, le compteur étant un compteur d'eau.

13. Procédé d'affichage, mis en oeuvre dans un compteur selon l'une des revendications précédentes et comprenant les étapes de :

- acquérir des mesures de l'orientation du compteur (1) produites par le capteur d'orientation (3) ;
- adapter l'orientation de l'affichage des caractères sur l'afficheur (7) en fonction de l'orientation du compteur.

14. Programme d'ordinateur comprenant des instructions qui conduisent l'unité de traitement (5) du compteur (1) selon l'une des revendications 1 à 12 à exécuter les étapes du procédé d'affichage selon la revendication 13.

15. Support d'enregistrement lisible par ordinateur, sur lequel est enregistré le programme d'ordinateur selon la revendication 14.

**Patentansprüche**

1.  Zähler (1), umfassend eine Hauptmessvorrichtung, die ausgebildet ist, Messungen mindestens einer Größe bezüglich eines Elements zu erzeugen, das über den Zähler (1) an eine Anlage verteilt wird, die mit dem Zähler (1) verbunden ist, wobei der Zähler ferner umfasst:

    - ein Anzeigegerät (7);
    - einen Ausrichtungssensor (3), der ausgebildet ist, Messungen der Ausrichtung des Zählers in Bezug auf die Richtung der Erdanziehungskraft zu erzeugen;
    - eine Verarbeitungseinheit (5), die mit dem Ausrichtungssensor und dem Anzeigegerät verbunden und ausgebildet ist, eine Ausrichtung einer Zeichenanzeige (14, 16, 17) auf dem Anzeigegerät in Abhängigkeit von der Ausrichtung des Zählers anzupassen; wobei der genannte Zähler (1) **dadurch gekennzeichnet ist, dass**:

    die Verarbeitungseinheit (5) ferner ausgebildet ist, um eine Installation des Zählers (1) in einer Betriebsposition zu detektieren, um mindestens eine Ausrichtungsmessung im Anschluss an die genannte Detektion zu erfassen und danach, falls erforderlich, die Ausrichtung der Anzeige in Abhängigkeit von der Ausrichtungsmessung anzupassen;
    wobei die Verarbeitungseinheit (5) ferner ausgebildet ist, die Installation des Zählers (1) in der Betriebsposition zu detektieren, wenn mindestens eine von der Hauptmessvorrichtung gemessene Größe größer als ein vorbestimmter Messschwellenwert ist oder wenn ein Vorhandensein des Elements von dem Zähler detektiert wird.

2.  Zähler nach Anspruch 1, ferner umfassend ein Detektororgan (6), das ausgebildet ist, ein externes Phänomen zu detektieren, wobei die Verarbeitungseinheit ausgebildet ist, mindestens eine Ausrichtungsmessung im Anschluss an eine Detektion des genannten externen Phänomens durch das Detektororgan zu erfassen und dann, falls erforderlich, die Ausrichtung der Anzeige in Abhängigkeit von der Ausrichtungsmessung anzupassen.

3.  Zähler nach Anspruch 2, wobei das Detektororgan (6) ausgebildet ist, eine von einer Einzelperson erzeugte Betätigung zu detektieren, wobei die Verarbeitungseinheit (5) ausgebildet ist, die Installation des Zählers (1) in der Betriebsposition im Anschluss an eine Detektion der genannten Betätigung durch das Detektororgan zu detektieren.

4.  Zähler nach Anspruch 2, wobei das Detektororgan ein Drucktaster ist.

5.  Zähler nach Anspruch 2, wobei das Detektororgan derart ausgebildet ist, dass eine Einzelperson der Ausrichtung der Anzeige einen ausgewählten Wert zuweisen kann, indem sie auf das Detektororgan einwirkt.

6.  Zähler nach einem der vorhergehenden Ansprüche, bei dem die Verarbeitungseinheit (5) ausgebildet ist, um, wenn die Ausrichtungsmessungen nicht verfügbar oder fehlerhaft sind, der Ausrichtung der Anzeige einen vordefinierten Wert zuzuweisen.

7.  Zähler nach einem der vorhergehenden Ansprüche, ferner umfassend ein Steuergerät (8), das mit der Verarbeitungseinheit verbunden oder in diese integriert und ausgebildet ist, die Anzeige der Zeichen auf dem Anzeigegerät (7) zu steuern.

8.  Zähler nach Anspruch 7, bei dem das Steuergerät (8) ausgebildet ist, die Ausrichtung der Anzeige anzupassen, um in Abhängigkeit von der Ausrichtung des Zählers (1) eine optimierte Kodierung unter einer Vielzahl von gespeicherten Kodierungen auszuwählen, die jeweils anzuzeigende Zeichen in von dem Steuergerät (8) erzeugte Steuersignale kodieren.

9.  Zähler nach Anspruch 7, bei dem das Steuergerät (8) ausgebildet ist, die Ausrichtung der Anzeige anzupassen, um in Abhängigkeit von der Ausrichtung des Zählers (1) eine optimierte Assoziationstabelle unter einer Vielzahl von gespeicherten Assoziationstabellen auszuwählen, die jeweils von dem Steuergerät (8) erzeugte Steuersignale mit Anschlussstiften des Steuergeräts (8) verknüpfen, die mit Anschlussstiften des Anzeigegeräts (7) verbunden sind.

10. Zähler nach einem der vorhergehenden Ansprüche, ferner umfassend ein Kommunikationsmodul (4), das ausgebildet ist, die Ausrichtungsmessungen an eine Einheit (10) zu übertragen, die sich außerhalb des Zählers befindet.

11. Zähler nach einem der vorhergehenden Ansprüche, wobei die Verarbeitungseinheit ferner ausgebildet ist, Messungen mindestens einer Größe in Abhängigkeit von der Ausrichtung des Zählers zu korrigieren.

12. Zähler nach Anspruch 11, wobei der Zähler ein Wasserzähler ist.

13. Anzeigeverfahren, das in einem Zähler nach einem der vorhergehenden Ansprüche durchgeführt wird und die Schritte umfasst:

> - Erfassen der Messungen der Ausrichtung des Zählers (1), die von dem Ausrichtungssensor (3) erzeugt werden;
> - Anpassen der Ausrichtung der Anzeige der Zeichen auf dem Anzeigegerät (7) in Abhängigkeit von der Ausrichtung des Zählers.

14. Computerprogramm, umfassend Anweisungen, die die Verarbeitungseinheit (5) des Zählers (1) nach einem der Ansprüche 1 bis 12 dazu veranlassen, die Schritte des Anzeigeverfahrens nach Anspruch 13 auszuführen.

15. Computerlesbarer Aufzeichnungsträger, auf dem das Computerprogramm nach Anspruch 14 gespeichert ist.


**Claims**

1. Meter (1) comprising a main measuring device to produce measurements of at least one magnitude relating to an element distributed via the meter (1) to an installation connected to the meter (1), the meter comprising, in addition:

> a display unit (7);
> an orientation sensor (3) arranged to produce measurements of the orientation of the meter with respect to the direction of the Earth's gravity;
> a processing unit (5) connected to the orientation sensor and to the display unit, and arranged to adapt an orientation of a character display (14, 16, 17) on the display unit according to the orientation of the meter; said meter (1) being **characterized by** :

>> the processing unit (5) being further arranged to detect an installation of the meter (1) in an operational position, to acquire at least one orientation measurement following said detection, then to adapt, if necessary, the orientation of the display according to the orientation measurement;
>> the processing unit (5) being further arranged to detect the installation of the meter (1) in the operational position when at least one magnitude measured by the main measuring device is greater than a predetermined measuring threshold or when a presence of the element is detected by the meter.

2. Meter according to claim 1, further comprising a detecting member (6) arranged to detect an external phenomenon, the processing unit being arranged to acquire at least one orientation measurement following a detection of said external phenomenon by the detecting member, then to adapt if necessary, the orientation of the display according to the orientation measurement.

3. Meter according to claim 2, the detecting member (6) being arranged to detect a control produced by an individual, the processing unit (5) being arranged to detect the installation of the meter (1) in the operational position following a detection by the detecting member of said control.

4. Meter according to claim 2, the detecting member being a pushbutton.

5. Meter according to claim 2, the detecting member being arranged such that an individual can give to the orientation of the display, a value chosen by acting on the detecting member.

6. Meter according to one of the preceding claims, wherein the processing unit (5) is arranged to, if the orientation measurements are unavailable or erroneous, give to the orientation of the display, a predefined value.

7. Meter according to one of the preceding claims, further comprising a controller (8) connected to or integrated in the processing unit, and arranged to control the displaying of the characters on the display unit (7).

8. Meter according to claim 7, wherein the controller (8) is arranged, to adapt the orientation of the display, to select, according to the orientation of the meter (1), an optimised coding from among a plurality of memorised coding which code each of the characters to be displayed in control signals produced by the controller (8).

9. Meter according to claim 7, wherein the controller (8) is arranged, to adapt the orientation of the display, to select, according to the orientation of the meter (1), an optimised association table from among a plurality of memorised association tables which each associate each of the control signals produced by the controller (8) with pins of the controller (8) connected to pins of the display unit (7).

10. Meter according to one of the preceding claims, further comprising a communication module (4) arranged to transmit the orientation measurements to an entity (10) located outside of the meter.

11. Meter according to one of the preceding claims, the processing unit being further arranged to correct measurements of at least one magnitude according to the orientation of the meter.

12. Meter according to claim 11, the meter being a water meter.

13. Display method, implemented in a meter according to one of the preceding claims and comprising steps of:

   acquiring measurements of the orientation of the meter (1) produced by the orientation sensor (3);
   adapting the orientation of the character display on the display unit (7) according to the orientation of the meter.

14. Computer program comprising instructions which lead to the processing unit (5) of the meter (1) according to one of claims 1 to 12, executing the steps of the display method according to claim 13.

15. Computer-readable storage medium storing the computer program according to claim 14.

Fig. 1

Fig. 2

Fig. 3

Fig. 4

Fig. 5

| LCD pins | Seg1 | Seg2 | Seg3 | Seg4 |
|----------|------|------|------|------|
| Com1 | A1 | B1 | C1 | D1 |
| Com2 | A2 | B2 | C2 | D2 |
| Com3 | A3 | B3 | C3 | D3 |
| Com4 | A4 | B4 | C4 | D4 |
| Com5 | A5 | B5 | C5 | D5 |
| Com6 | A6 | B6 | C6 | D6 |
| Com7 | A7 | B7 | C7 | D7 |
| Com8 | A8 | B8 | C8 | D8 |
| Com9 | A9 | B9 | C9 | D9 |

Fig. 6

| Affichage "normal" | | | | | |
|---|---|---|---|---|---|
| Signaux de commande | | S1 | S2 | S3 | S4 |
| | LCD pins | Seg1 | Seg2 | Seg3 | Seg4 |
| CMD1 | Com1 | A1 | B1 | C1 | D1 |
| CMD2 | Com2 | A2 | B2 | C2 | D2 |
| CMD3 | Com3 | A3 | B3 | C3 | D3 |
| CMD4 | Com4 | A4 | B4 | C4 | D4 |
| CMD5 | Com5 | A5 | B5 | C5 | D5 |
| CMD6 | Com6 | A6 | B6 | C6 | D6 |
| CMD7 | Com7 | A7 | B7 | C7 | D7 |
| CMD8 | Com8 | A8 | B8 | C8 | D8 |
| fixé | Com9 | A9 | B9 | C9 | D9 |

| Affichage "retourné" | | | | | |
|---|---|---|---|---|---|
| Signaux de commande | | S4 | S3 | S2 | S1 |
| | LCD pins | Seg1 | Seg2 | Seg3 | Seg4 |
| fixé | Com1 | A1 | B1 | C1 | D1 |
| CMD8 | Com2 | A2 | B2 | C2 | D2 |
| CMD6 | Com3 | A3 | B3 | C3 | D3 |
| CMD7 | Com4 | A4 | B4 | C4 | D4 |
| CMD5 | Com5 | A5 | B5 | C5 | D5 |
| CMD3 | Com6 | A6 | B6 | C6 | D6 |
| CMD4 | Com7 | A7 | B7 | C7 | D7 |
| CMD2 | Com8 | A8 | B8 | C8 | D8 |
| CMD1 | Com9 | A9 | B9 | C9 | D9 |

Fig. 7

Fig. 8

Fig. 9

| Température du fluide | Débit d'eau mesuré par le compteur | | | | | | |
|---|---|---|---|---|---|---|---|
| | Q1=2L/h | Q2=5L/h | Q3=10L/h | Q4=100L/h | Q5=500L/h | Q6=1000L/h | Q7=5000L/h |
| T 1(5°C) | Erreur11 H Erreur11 V | Erreur12 H Erreur12 V | Erreur13 H Erreur13 V | Erreur14 H Erreur14 V | Erreur15 H Erreur15 V | Erreur16 H Erreur16 V | Erreur17 H Erreur17 V |
| T 2(10°C) | Erreur21 H Erreur21 V | Erreur22 H Erreur22 V | Erreur23 H Erreur23 V | Erreur24 H Erreur24 V | Erreur25 H Erreur25 V | Erreur26 H Erreur26 V | Erreur27 H Erreur27 V |
| T 3(20°C) | Erreur31 H Erreur31 V | Erreur32 H Erreur32 V | Erreur33 H Erreur33 V | Erreur34 H Erreur34 V | Erreur35 H Erreur35 V | Erreur36 H Erreur36 V | Erreur37 H Erreur37 V |
| T 4(30°C) | Erreur41 H Erreur41 V | Erreur42 H Erreur42 V | Erreur43 H Erreur43 V | Erreur44 H Erreur44 V | Erreur45 H Erreur45 V | Erreur46 H Erreur46 V | Erreur47 H Erreur47 V |
| T 5(40°C) | Erreur51 H Erreur51 V | Erreur52 H Erreur52 V | Erreur53 H Erreur53 V | Erreur54 H Erreur54 V | Erreur55 H Erreur55 V | Erreur56 H Erreur56 V | Erreur57 H Erreur57 V |
| T 6(50°C) | Erreur61 H Erreur61 V | Erreur62 H Erreur62 V | Erreur63 H Erreur63 V | Erreur64 H Erreur64 V | Erreur65 H Erreur65 V | Erreur66 H Erreur66 V | Erreur67 H Erreur67 V |
| T 7(60°C) | Erreur71 H Erreur71 V | Erreur72 H Erreur72 V | Erreur73H Erreur73 V | Erreur74 H Erreur74 V | Erreur75 H Erreur75 V | Erreur76 H Erreur76 V | Erreur77 H Erreur77 V |
| T 8(70°C) | Erreur81 H Erreur81 V | Erreur82 H Erreur82 V | Erreur83 H Erreur83 V | Erreur84 H Erreur84 V | Erreur85 H Erreur85 V | Erreur86 H Erreur86 V | Erreur87 H Erreur87 V |
| T 9(80°C) | Erreur91 H Erreur91 V | Erreur92 H Erreur92 V | Erreur93 H Erreur93 V | Erreur94 H Erreur94 V | Erreur95 H Erreur95 V | Erreur96 H Erreur96 V | Erreur97 H Erreur97 V |

Fig. 10

Fig. 11

**EP 4 024 011 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 6675900 B